# EUROPÄISCHE PATENTSCHRIFT

(11) **EP 2 371 000 B1**
(45) Veröffentlichungstag und Bekanntmachung des Hinweises auf die Patenterteilung: **26.10.2016**
(21) Anmeldenummer: 09771691.4
(22) Anmeldetag: 27.11.2009
(51) Int. Cl.: H05K 1/02, H01L 21/48, H01L 23/373, H01L 25/16, H01L 33/64, H01L 25/075, H05K 1/18, H05K 3/00, H05K 3/34

(54) **VERFAHREN ZUR FERTIGUNG VON LEUCHTMITTELN**
METHOD FOR PRODUCING LAMPS
PROCÉDÉ POUR PRODUIRE DES MOYENS D'ÉCLAIRAGE

(30) Priorität: 30.12.2008 DE 102008063325
(43) Veröffentlichungstag der Anmeldung: 05.10.2011
(60) Teilanmeldung: 12186956.4
(73) Patentinhaber: OSRAM Opto Semiconductors GmbH, 93055 Regensburg (DE)
(72) Erfinder: GRÖTSCH, Stefan, 93077 Bad Abbach (DE); MÜLLER, Klaus, 93186 Pettendorf (DE)
(74) Vertreter: Epping - Hermann - Fischer
(86) Internationale Anmeldenummer: PCT/DE2009/001693
(87) Internationale Veröffentlichungsnummer: WO 2010/075831

(56) Entgegenhaltungen:
- EP-A2- 1 575 084
- WO-A2-2008/040307
- DE-A1- 2 528 000
- DE-A1-102005 031 336
- DE-A1-102008 001 221
- US-A1- 2006 289 887

## Beschreibung

Verfahren zur Fertigung von Leuchtmitteln Diese Patentanmeldung beansprucht die Priorität der deutschen Patentanmeldung 102008063325.9.

Die Erfindung betrifft ein Verfahren zur Fertigung von Leuchtmitteln und insbesondere ein Verfahren zur Fertigung von Baugruppen mit optoelektronischen Bauelementen. Anwendungen mit optoelektronischen Bauelementen gewinnen zunehmend an Bedeutung. Hierzu gehören neben einfachen Leuchtmitteln wie Lampen auch Hintergrundbeleuchtungen, beispielsweise für LCD-Bildschirme oder Monitore. Dabei bezeichnet der Begriff optoelektronischen Bauelement ein Element, das in einem Betrieb bei einer Versorgung mit elektrischer Energie Licht emittiert. Hierzu gehören neben Leuchtdioden auf Halbleiterbasis auch organische Leuchtdioden, Kombinationen aus organischen und anorganischen zur Lichtemission geeignete Verbindungen und andere lichtemittierende Bauelemente.

In einigen Anwendungen sind sehr hohe Lichtleistungen erforderlich, beispielsweise für Projektoren. Hierbei werden vor allen Dingen Leuchtkörper eingesetzt, die in unterschiedlichen Farben Licht emittieren, sodass sich eine weiße Mischfarbe ergibt.

Um möglichst hohe Leuchtdichten zu erreichen, werden häufig verschiedene optoelektronische Bauelemente auf einem gemeinsamen Chip platziert und anschließend durch entsprechende Zuleitungen angesteuert und mit Energie versorgt. Die Unterteilung in verschiedene einzelne Chips hat den Vorteil, dass sich einerseits Leuchtkraft und Farbe besser regulieren lassen und andererseits die Ausfallwahrscheinlichkeit verringert bzw. die Reparaturmöglichkeiten verbessert werden. Demgegenüber kann sich aufgrund einer ungenauen Platzierung eine ungleichmäßige Lichtverteilung und Leuchtdichte ergeben, was sich störend bemerkbar machen kann

In der Druckschrift WO 2008/040307 A2 wird ein Verfahren zur Herstellung einer Anordnung optoelektronischer Bauelemente beschrieben, bei dem Befestigungsbereiche auf einem ersten Anschlussträger hergestellt werden, ein Lotmaterial in die Befestigungsbereiche eingebracht wird, und ein zweiter Anschlussträger mit dem Lotmaterial auf den ersten Anschlussträger aufgelötet wird.

Eine zu lösende Aufgabe besteht darin, ein Verfahren zur Fertigung von Leuchtmitteln anzugeben, bei dem die Wärmeableitung von den Leuchtmitteln verbessert ist.

Diese Aufgabe wird mit dem Gegenstand des unabhängigen Verfahrensanspruchs gelöst.

Weiterbildungen und Ausgestaltungsformen der Erfindung sind Gegenstand der Unteransprüche.

Bei dem Verfahren zur Fertigung von Leuchtmitteln wird ein als Wärmesenke dienender Träger bereitgestellt, der einen flächigen Chipmontagebereich umfasst, und der flächige Chipmontagebereich zur Erzeugung eines ersten Teilbereichs und wenigstens einen zweiten Teilbereichs strukturiert, wobei der erste Teilbereich nach dem Strukturieren lotabweisend ist. Das Verfahren umfasst weiterhin das Aufbringen eines Lotes auf den flächigen Chipmontagebereich, so dass dieses den wenigstens einen zweiten Teilbereich benetzt, das Aufbringen wenigstens eines optoelektronischen Bauelementes auf das Lot in dem wenigstens einen zweiten Teilbereich, und das Ausbilden einer elektrischen Kontaktierung geeignet zur Zuführung elektrischer Energie an das optoelektronische Bauelement. Bei dem Verfahren wird eine Dünnleiterplatte mit einer Aussparung, wenigstens einer metallischen Leitungsbahn und wenigstens einem Kontaktbereich ausgebildet, und die Dünnleiterplatte auf den Träger derart aufgebracht, dass die Aussparung über dem Chipmontagebereich zu liegen kommt, wobei das Aufbringen des wenigstens einen optoelektronischen Bauelements vor oder nach dem Aufbringen der Dünnleiterplatte erfolgt.

Nach dem vorgeschlagenen Prinzip kann die Leuchtdichte und die Gleichmäßigkeit, vereinfacht auch als Etendue bezeichnet durch eine geeignete Strukturierung eines flächigen Chipmontagebereichs, auf dem die einzelnen Leuchtkörper aufgebracht sind, verbessert werden.

Zu diesem Zweck wird ein als Wärmesenke dienender Träger bereitgestellt, der einen flächigen Chipmontagebereich umfasst. Der Träger kann einen Metallkern, ein Metallsubstrat mit einem derartigen flächigen Chipmontagebereich aufweisen. Ebenso kann als Träger ein Keramiksubstrat mit einem metallisierten Chipmontagebereich, ein PCB (Printed Circuit Board) mit einem flächigen ggf. metallisierten Chipmontagebereich oder auch ein Leadframe mit einem derartigen Bereich vorgesehen sein. Abhängig von dem jeweiligen Träger wird der spätere Chipmontagebereich vorbehandelt, beispielsweise metallisiert. Als Träger ist jedes SMT-fähiges Substrat geeignet, dass in Teilbereichen metallisiert werden kann, um einen flächigen Chipmontagebereich zu bilden

Der flächige Chipmontagebereich wird zur Erzeugung eines ersten Teilbereichs und wenigstens eines zweiten Teilbereichs strukturiert. Die Strukturierung erfolgt derart, dass der erste Teilbereich nach dem Strukturieren eine lotabweisende Eigenschaft aufweist. Alternativ wird durch die Strukturierung des Chipmontagebereichs der erste Teilbereich lotabweisend, so dass der Chipmontagebereich im ersten Teilbereich lotabweisend und im zweiten Teilbereich lotanziehend ist.

Unter den Begriffen "lotabweisend" oder "lotabweisende Eigenschaft" wird eine Eigenschaft des ersten Teilbereichs verstanden, die dazu führt, dass bei einem späteren Aufbringen eines Lotes oder Lotmittels diese den ersten Teilbereich nicht oder kaum benetzen. Folglich konzentriert sich nach dem Aufbringen eines Lots auf dem flächigen Chipmontagebereich das Lot vor allem im zweiten Teilbereich und benetzt diesen.

Anschließend wird wenigstens ein optoelektronischer Körper, vorzugsweise ein optoelektronisches Halbleiterbauelement, auf das Lot in dem wenigstens einen zweiten Teilbereich aufgebracht und mit dem Träger fest verbunden. Durch die Strukturierung und die Erzeugung des lotabweisenden ersten Teilbereichs wird der auf dem Lot aufgebrachte optoelektronische Körper somit im zweiten Teilbereich fixiert. Während der Fertigung im flüssigen Zustand des Lots "folgt" der auf dem Lot schwimmende optoelektronische Körper dem Lot in den zweiten Teilbereich, da nur in diesem Teilbereich das Lot den Chipmontagebereich benetzt.

Die Strukturierung des flächigen Chipmontagebereichs in Teilbereiche mit lotabweisender und lotanziehender oder benetzender Eigenschaft erlaubt somit Teilbereiche auszubilden, in denen ein oder mehrere optoelektronische Körper fixiert und durch ein vorher aufgebrachtes Lot mit dem Chipmontagebereich verbunden werden.

Anschließend wird eine elektrische Kontaktierung, geeignet zur Zuführung elektrischer Energie an den optoelektronischen Leuchtkörper, ausgebildet.

In einer Ausgestaltung ist es diesbezüglich zweckmäßig, den als Wärmesenke dienenden Träger bereits als Elektrode bzw. den flächigen Chipmontagebereich als Elektrode auszubilden. In diesem Fall dient der flächige Chipmontagebereich nicht nur als Teil der Wärmesenke, sondern auch als elektrischer Kontakt an das optoelektronische Bauelement.

In einer Ausgestaltung umfasst der flächige Chipmontagebereich in dem zweiten Teilbereich wenigstens eine metallische, durch das Lot zumindest teilweise benetzbare Teilschicht. Die Teilschicht kann beispielsweise Gold, Silber oder ein anderes nicht oxidierendes Material umfassen. In einer Ausführungsform umfasst der flächige Montagebereich verschiedene übereinander angeordnete Teilschichten aus unterschiedlichen Metallen. Diese Metalle können beispielsweise Nickel, Kupfer, Aluminium, Silber, Gold, Titan oder Wolfram umfassen. Dabei kann eine Goldschicht über einer Nickelschicht aufgebracht sein, um eine Diffusion von Gold in darunter liegende Teilschichten, beispielsweise aus Kupfer, zu verhindern.

In einer Ausgestaltungsform des Verfahrens wird vorgeschlagen, zur Strukturierung des Chipmontagebereiches und Erzeugung des ersten Teilbereichs Teile der Goldschicht innerhalb des Chipmontagebereichs zu entfernen und die darunter liegende Nickelschicht zu oxidieren. Durch die Oxidation der darunter liegenden Schicht, insbesondere einer Nickelschicht, wird ein erster Teilbereich geschaffen, der eine lotabweisende Eigenschaft aufweist, sodass das darauf aufgebrachte Lot diesen Teilbereich nicht oder nur sehr gering benetzt.

In einer Ausgestaltung wird eine derartige Strukturierung erreicht, indem eine optische Lichtquelle, vorzugsweise ein Laser, bereitgestellt wird. Anschließend wird zur Erzeugung der Strukturierung des flächigen Chipmontagebereichs der erste Teilbereich des flächigen Chipmontagebereichs mit der optischen Lichtquelle bestrahlt und so wenigstens eine der metallischen Teilschichten oxidiert. In einem Ausführungsbeispiel wird durch die Bestrahlung ein Oberflächenmaterial des ersten Teilbereichs geschmolzen oder verdampft und ein darunter liegendes freigelegtes Material oxidiert. Dieses darunter liegende oxidierte Material weist die lotabweisenden Eigenschaften auf. Beispielsweise kann das Oberflächenmaterial Gold, Aluminium oder Silber sein, welches durch die Bestrahlung vorzugsweise mittels eines Lasers verdampft wird. Ein eine weitere Teilschicht bildendes darunter liegendes Material wird freigelegt. Dieses kann beispielsweise Nickel umfassen. Das freigelegte Material wird dann oxidiert, beispielsweise mit Hilfe der optischen Strahlungsquelle, aber auch durch andere physikalische oder chemische Verfahren.

Im Fall einer freigelegten Nickelschicht wird diese durch den Laserstrahl oxidiert und das so oxidierte Nickel ist lotabweisend.

Allgemein kann zur Erzeugung eines Materials mit einer lotabweisenden Eigenschaft ein Oberflächenmaterial des flächigen Chipmontagebereichs durch physikalische oder chemische Verfahren chemisch verändert werden und eine Verbindung eingehen.

In einer anderen Ausgestaltung wird der flächige Chipmontagebereich strukturiert, indem eine Lötstoppschicht auf dem flächigen Chipmontagebereich aufgebracht wird. Diese Lötstoppschicht ist ebenfalls lotabweisend. Anschließend wird die Lötstoppschicht zur Erzeugung des ersten und zweiten Teilbereichs strukturiert und dann im zweiten Teilbereich entfernt, sodass die darunter liegende Oberfläche des zweiten Teilbereichs des Chipmontagebereichs wieder freigelegt wird. Eine Strukturierung der Lötstoppschicht kann beispielsweise durch geeignete Maskenverfahren und Belichtung erfolgen. Die übrige Lötstoppschicht verbleibt unter Bildung des ersten Teilbereichs auf dem Chipmontagebereich.

In einer weiteren Ausgestaltung wird eine Lötstoppschicht auf den flächigen Chipmontagebereich direkt selektiv aufgebracht und so der erste Teilbereich definiert. Auch hierbei ist die Lötstoppschicht lotabweisend. Ein derartiges Aufbringen kann beispielsweise über ein Schablonenverfahren oder ein Lotdispensverfahren erfolgen. Sofern notwendig, lassen sich anschließend durch Freilegen und/oder Bearbeiten von Abschnitten des zweiten Teilbereichs diese von einer ungewünscht aufgebrachten Lötstoppschicht reinigen, sodass der zweite Teilbereich wieder die durch Lot benetzbare Oberfläche umfasst.

Zum Aufbringen eines Lots auf den flächigen Chipmontagebereichs innerhalb des zweiten Teilbereichs bietet sich ein Lotdispensverfahren an. Dies ist insbesondere von Vorteil, wenn der Chipmontagebereich innerhalb des Trägers tiefer gelegt ist als der ihn umgebende Bereich, der beispielsweise die Zuleitung oder andere elektrische Kontakte enthalten kann.

In einer anderen Ausgestaltung wird ein als Wärmesenke dienender Träger mit einem flächigen Chipmontagebereich bereitgestellt und auf diesem eine Kontaktierungsschicht aufgebracht. Der Träger kann ein PCB, ein Keramiksubstrat, ein Metallkern, ein Kunststoff oder auch eine Kombination aus diesen Trägermaterialien sein.

Außerhalb des Chipmontagebereichs wird eine dielektrische Schicht flächig auf den Träger aufgebracht, um einen Kurzschluss mit dem Chipmontagebereich zu vermeiden. Auf der dielektrischen Schicht werden nun Leiterbahnen und Kontaktpads sowie andere notwendige Elemente aufgedampft, abgeschieden oder anderweitig aufgebracht. Der Chipmontagebereich wird weiterhin zur Erzeugung des ersten bzw. zweiten Teilbereichs entsprechend strukturiert und anschließend ein Lotmaterial, beispielsweise mittels Lotdispensverfahrens, auf den wenigstens einen zweiten Teilbereich abgeschieden. Durch die Strukturierung des flächigen Chipmontagebereichs wird das Lot in den wenigstens einen zweiten Teilbereich gezwungen und benetzt diesen. Anschließend können verschiedene optoelektronische Bauelemente auf dem Lot in dem wenigstens einen zweiten Teilbereich aufgesetzt und durch Erhitzen des Lots innig mit dem Chipmontagebereich verbunden werden. In einem letzten Schritt wird eine elektrische Kontaktierung zur Zuführung elektrischer Energie vorgenommen.

Die elektrische Kontaktierung kann beispielsweise über Wirebonden erfolgen, bei dem Bonddrähte einerseits mit den optoelektronischen Leuchtkörpern und andererseits mit Kontaktpads außerhalb des Chipmontagebereichs verbunden werden.

In einer weiteren Ausgestaltung der Erfindung wird der Chipmontagebereich in verschiedene zweite Teilbereiche unterteilt, von denen jeweils zwei benachbarte durch einen Abschnitt des ersten Teilbereichs getrennt sind. Auf diese Weise lassen sich mehrere optoelektronische Leuchtkörper in räumlich leicht getrennten, jedoch sehr eng beabstandeten Bereichen auf dem Chipmontagebereich befestigen. Beispielsweise ist es möglich, optoelektronische Leuchtkörper, ausgeführt zur Emission von Licht unterschiedlicher Wellenlänge auf dem Chipmontagebereich so anzuordnen, dass sich ein gewünschtes Gesamtleuchtmuster ergibt. Insbesondere Mischfarben, beispielsweise die Farbe weiß, lassen sich durch Anordnen verschiedener Leuchtkörper auf dem Chipmontagebereich realisieren. Dabei kann durch eine geeignet dünne Strukturierung des ersten Teilbereichs zwischen zwei Teilbereichen ein im Wesentlichen lückenloses Aneinanderfügen der verschiedenen optoelektronischen Leuchtkörper erreicht werden.

Im Folgenden wird die Erfindung anhand des Ausführungsbeispiels der Figuren 5A bis 5D und mehrerer weiterer Beispiele, welche in den Figuren 1 bis 4 dargestellt sind und nicht der Erfindung entsprechen, unter Bezugnahme auf die Zeichnungen im Detail näher erläutert. Es zeigen:
- Figur 1: eine Querschnittsdarstellung eines Leuchtmittels,
- Figur 2: eine Draufsicht über einen flächigen Chipmontagebereich eines Leuchtmittels,

- Figur 3: eine Draufsicht über einen Chipmontagebereich in einer alternativen Ausführung,
- Figuren 4A bis 4E: Querschnittsdarstellungen sowie Draufsichten zur Erläuterung eines Beispiels eines Verfahrens,
- Figuren 5A bis 5D: ein Ausführungsbeispiel des erfindungsgemäßen Verfahrens zur Fertigung von Leuchtmitteln in Draufsicht.

In den folgenden Beispielen und Figuren können gleiche oder gleich wirkende Bestandteile mit gleichen Bezugszeichen versehen sein. Die Figuren und die Größenverhältnisse, insbesondere auch die Größenverhältnisse einzelner Teilbereiche und Schichten zueinander, sind grundsätzlich nicht als maßstabsgerecht zu betrachten. Vielmehr dienen sie zur Verdeutlichung einzelner Aspekte der Erfindung. Zum besseren Verständnis oder besseren Darstellbarkeit können diese übertrieben groß bzw. dick dargestellt sein.

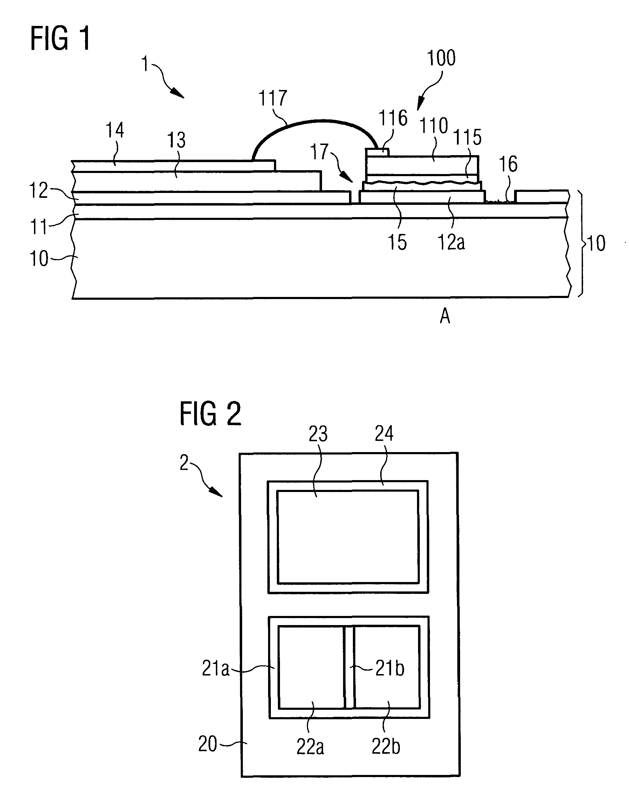

Figur 1 zeigt in Querschnittsdarstellung einen Ausschnitt eines Leuchtmittels. Das Leuchtmittel 1 ist hierzu auf einem als Wärmesenke dienenden Träger 10a aufgebracht. Dieser Träger umfasst einen durchgehenden Kupferkern 10, der eine ausreichende Stabilität aufweist und dessen Wärmekapazität ausreichend groß ist, um die im Betrieb durch den Leuchtkörper 100 entstandene Wärme abzuführen. Der Kupferkern 10 hat darüber hinaus den Vorteil, dass er als rückseitige Elektrode für den Leuchtkörper 100 dienen kann.

Alternativ kann auch ein Keramiksubstrat als Träger mit einem metallisierten Chipmontagebereich verwendet werden.

Auf dem Kupferkern 10 sind zur besseren Befestigung von optoelektronischen Bauelementen 100 zusätzliche Teilschichten 11 und 12 aufgebracht. Diese ermöglichen eine gute Benetzung eines später aufgebrachten Lots, auf dem der Leuchtkörper 100 befestigt wird. Die einzelnen Teilschichten umfassen im vorliegenden Ausführungsbeispiel eine Teilschicht aus Nickel 11 sowie eine darauf dünn aufgebrachte Goldschicht 12. Die Goldschicht 12 verhindert eine ungewünschte Oxidation der darunter befindlichen Schichten und verlängert somit die Lebensdauer.

Auf der Goldschicht 12, die über die Nickelteilschicht 11 mit dem Kupferkern 10 in elektrisch leitendem Kontakt steht, ist in Teilbereichen eine dielektrische Schicht 13 aufgebracht. Auf dieser sind Kontaktfahnen 14 aufgedampft, die später über Bonddrähte 117 die Kontaktierung an den Leuchtkörper 100 ermöglichen.

Im Chipmontagebereich A sind die Teilschichten 11 und 12 in einzelnen Teilbereichen 17 strukturiert, um eine Fixierung des Leuchtkörpers 100 auf einem Lot 15 zu gewährleisten. Dieses Lot 15 ist in einem zweiten Teilbereich 12a aufgebracht, der von den strukturierten Teilbereichen 17 umgeben ist. Wie zu erkennen, benetzt das Lot die strukturierten Teilbereiche 17 nicht, sondern lediglich den zweiten Teilbereich 12a des Chipmontagebereichs. Das auf dem Lot aufgebracht und befestigte optoelektronische Bauelement wird so in dem zweiten Teilbereich 12a fixiert. Der Leuchtkörper 100, beispielsweise in Form einer Leuchtdiode umfasst eine rückseitig angeordnete Spiegelschicht 115 zur Verbesserung der Lichtauskopplung. Weiterhin enthält er eine oder mehrere Teilschichten 42, wobei wenigstens eine der Teilschichten eine zur Lichtemission geeignete Schicht aufweist. In einer Ausführungsform kann der Leuchtkörper als Dünnfilmleuchtdiode ausgebildet sein. Entsprechende Herstellungsarten derartige Leuchtkörper sind dem Fachmann bekannt, sodass von einer erneuten Erläuterung abgesehen wird.

In diesem Beispiel besitzt der Leuchtkörper 100 auf seiner Oberfläche einen Kontakt 116, der über einen Bonddraht 117 mit einem entsprechenden Kontaktpad und einer Kontaktfahne 14 auf der Oberfläche des Leuchtmittels und der dielektrischen Schicht 13 befestigt ist.

Die strukturierten ersten Teilbereiche 17 sind mit einer dünnen Nickeloxidschicht 16 bedeckt. Diese Nickeloxidschicht, die durch das Entfernen der Goldschicht und anschließende Oxidation erzeugt wird, ist lotabweisend, sodass beim Auftragen von Lotmaterial auf den Chipmontagebereich diese Teilbereiche nicht benetzt werden. Verschiedene Adhäsionskräfte ziehen anschließend einen auf dem Lot aufgebrachten Leuchtkörper in die Teilbereiche mit dem meisten Lot. Dadurch lässt sich durch Strukturieren des Chipmontagebereichs in Teilbereiche 17 und 12a die Position eines Leuchtkörpers innerhalb des Chipmontagebereichs genau festlegen.

Zur Herstellung eines derartigen Leuchtmittels wird in diesemBeispiel die Goldschicht 12a durch einen Laser entfernt. Hierzu wird ein Laserstrahl auf den Chipmontagebereich gerichtet und entlang geführt, sodass die Teilschicht 12 an den Stellen, die der Laserstrahl überstreicht, verdampft uns so die Teilbereiche 17 definiert. Die zusätzlich eingebrachte Energie durch den Laserstrahl oxidiert mit Sauerstoff gleichzeitig die darunter liegende Nickelschicht 11, welche dann die lotabweisenden Eigenschaften aufweist. Bei einem späteren Aufbringen des Lots ist darauf zu achten, dass ein verwendetes Flussmittel die Nickeloxidschicht 16 in den strukturierten Teilbereichen 17 nicht erneut reduziert und so die Strukturierung wieder aufhebt.

Nach der Strukturierung wird das Lot aufgebracht, beispielsweise durch ein Lotdispensverfahren. Die aufgebrachten Leuchtkörper 100 werden durch das Lot auf den zweiten Teilbereichen 12a fixiert und daran befestigt. Anschließend kann durch ein Wire-Bond-Verfahren die elektrische Kontaktierung mit Kontaktdrähten 117an den Leuchtkörper bzw. das optoelektronische Bauelement 100 erfolgen.

Figur 2 zeigt eine Draufsicht zur Erläuterung der unterschiedlichen Strukturierungsmöglichkeiten. Die Darstellung zeigt eine Draufsicht auf einen Chipmontagebereich, der einen Teil eines größeren Trägers bilden kann. Der Chipmontagebereich umfasst zwei Hauptbereiche, die jeweils für sich genommen wiederum in erste und zweite Teilbereiche strukturiert sind. In einem ersten Hauptbereich ist der Chipmontagebereich durch einen umlaufenden Teilbereich 24 strukturiert, sodass eine darin freiliegende Fläche 23 vorhanden ist. Diese bildet den zweiten Teilbereich. Auf der Fläche kann über ein Dispens-, ein Abscheide- oder ein Druckverfahren Lotmaterial aufgebracht werden. Der umlaufende Teilbereich 24 weist hingegen lotabweisende Eigenschaften auf, sodass sich das Lotmaterial im Wesentlichen im Bereich 23 konzentriert.

Ein zweiter Hauptbereich des strukturierten Chipmontagebereichs ist in zwei zweite Teilbereiche 22a und 22b unterteilt, die jeweils durch einen strukturierten Steg 21b voneinander getrennt sind. Auch hier sind die Teilbereiche 22a und 22b vollständig von einem lotabweisenden ersten Teilbereich 21a umgeben. Lotmaterial, was in den zwei zweiten Teilbereichen 22a und 22b abgeschieden wird, bleibt durch den strukturierten Steg 21b getrennt, sodass sich in dieser Ausführungsform beispielsweise zwei getrennte optoelektronische Bauelemente auf den einzelnen Teilbereichen 22a und 22b platzieren lassen.

Die Oberflächen der Teilbereiche 23 sowie 22a und 22b sind metallisch, sodass das aufgebrachte Lotmaterial einerseits zur Wärmeabfuhr in einem Betrieb des optoelektronischen Bauelements dient und andererseits gleichzeitig einen rückwärtigen elektrischen Kontakt bilden kann.

Die vorgeschlagene Strukturierung des Chipmontagebereichs erlaubt es, unterschiedlich geometrisch angeordnete Teilbereiche vorzusehen, in denen positionsgenau optoelektronische Bauelemente platziert werden können. Dadurch lassen sich insgesamt das Etendue und die Gleichmäßigkeit der Lichtabstrahlung verbessern.

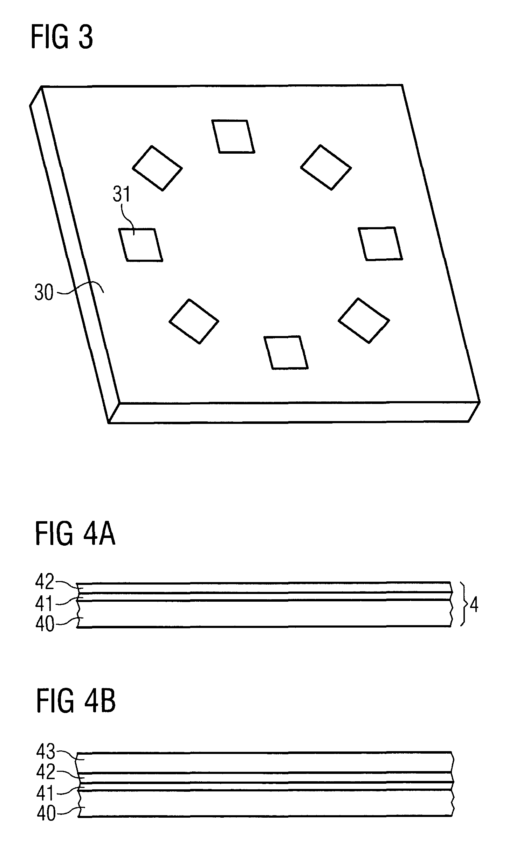

Figur 3 zeigt diesbezüglich einen Ausschnitt eines komplexeren Chipmontagebereichs, bei dem rechteckförmige Teilbereiche 31 strukturiert sind. Diese sind um einen gemeinsamen Mittelpunkt im Wesentlich kreisförmig angeordnet. Durch eine geeignete Beschaltung auf dem Träger lassen sich die optoelektronischen Bauelemente einzeln ansteuern und somit verschiedene Lichtapplikationen realisieren.

Unterschiedliche Größe und Form der Teilbereiche erlauben es, verschiedene optoelektronische Bauelemente vorzusehen und gleichzeitig deren unterschiedliche Abstrahlcharakteristiken zu berücksichtigen. Beispielsweise sind so auch Mischfarben erzeugbar, indem zur Lichtemission mit unterschiedlichen Wellenlängen geeignete Bauelemente benachbart zueinander angeordnet werden. Da der erste Teilbereich des Chipmontagebereichs, der nach dem Strukturieren die lotabweisende Eigenschaft aufweist, sehr geringe Strichdicken umfassen kann, lassen sich auch Bauelemente ausreichend nah nebeneinander platzieren, ohne dass es im Betrieb zu einer Verminderung der Lichtleistung oder der Abstrahlqualität kommt. Dabei ist es sogar möglich, durch geeignete Wahl der Dicke des lotabweisenden ersten Teilbereichs, der zwei benachbarte zweite Teilbereiche trennt, optoelektronische Bauelemente direkt nebeneinander mit einem Abstand kleiner als die Dicke des ersten Teilbereichs anzuordnen und zu befestigen.

Gleichzeitig wird es möglich, verschiedene optoelektronische Bauelemente einzeln anzusteuern, um so auch unterschiedliche Applikationen zu realisieren. Die Strukturierung des Chipmontagebereichs erlaubt die Verwendung kleinerer optoelektronischer Bauelemente, die gerade in der Fertigung fehlertoleranter und weniger ausfallträchtig als entsprechend großflächige Bauelemente sind.

Figuren 4A bis 4E zeigen ein Beispiel eines Verfahrens zur Fertigung von Baugruppen mit optoelektronischen Bauelementen.

In einem ersten Schritt gemäß Figur 4A wird ein als Wärmesenke dienender Träger 4 bereitgestellt. Dieser umfasst hier einen Kupferkern 40, der hauptsächlich als Wärmesenke dient, kann jedoch auch andere Materialien beinhalten. Auf dem Kupferkern 40 ist eine isolierende dielektrische Schicht 41 aufgebracht, welche einen Kurzschluss zwischen dem Kupferkern 40 und einer darüber befindlichen elektrisch leitfähigen Schicht 42 verhindern soll. Die dielektrische Schicht 41 weist hier ebenfalls eine ausreichende Wärmeleitfähigkeit auf.

Die Schicht 42 umfasst mehrere Metallisierungsschichten, welche hier aus Übersichtsgründen nicht näher dargestellt sind. Beispielsweise wird auf der dielektrischen Schicht 41 erst eine Metallisierung aus Kupfer aufgebracht. Auf diese wird anschließend Nickel aufgedampft und hierauf wiederum zur Verhinderung von Oxidation eine dünne Goldschicht aufgebracht. Die zwischen Kupfer und Gold angeordnete Nickelschicht ist notwendig, um eine Diffusion des Goldes in die Kupferschicht und eine anschließende Oxidation der Kupferschicht zu vermeiden. Anstelle der hier vorgeschlagenen Kupfer-Nickel-Gold-Beschichtung können auch andere Materialien verwendet werden. Beispielsweise eignen sich auch Teilschichten aus Kupfer und Silber bzw. Nickel und Silber für eine Befestigung später aufgebrachter Leuchtkörper.

Die dielektrische Schicht 41 ist wenige Mikrometer dicht, die darüber befindliche Kupfermetallisierungsschicht kann eine Dicke von 35µm bis 70 µm oder mehr aufweisen, die Nickelschicht ca. 10µm bis 20µm betragen.

Zur Strukturierung des Chipmontagebereichs und einer Unterteilung in erste und zweite Teilbereiche, wobei der erste Teilbereich lotabweisend wirken soll, wird nun großflächig eine Lötstoppschicht auf der Teilschicht 42 abgeschieden. Das Ergebnis ist in Figur 4B dargestellt. Anschließend wird mittels Fotomaskenverfahren die Lötstoppschicht strukturiert und in einzelne erste Teilbereiche 43a, 43b und 43c unterteilt. Als Lötstoppschicht eignet sich beispielsweise auch ein besonders unempfindlicher Fotolack, oder eine andere organische Schicht. Diese sollte zumindest solange beständig sein, bis die Fertigung des Bauelementes abgeschlossen ist.

Zwischen den einzelnen Teilbereichen 43a, 43b und 43c wird der nun nicht belichtete Teil der als Lötstoppschicht wirkenden Fotolackschicht entfernt und somit zweite Teilbereiche 44 definiert. Nach dem Entfernen der nicht belichteten Bereiche liegt die Oberfläche der Metallisierungsschicht 42 wieder frei.

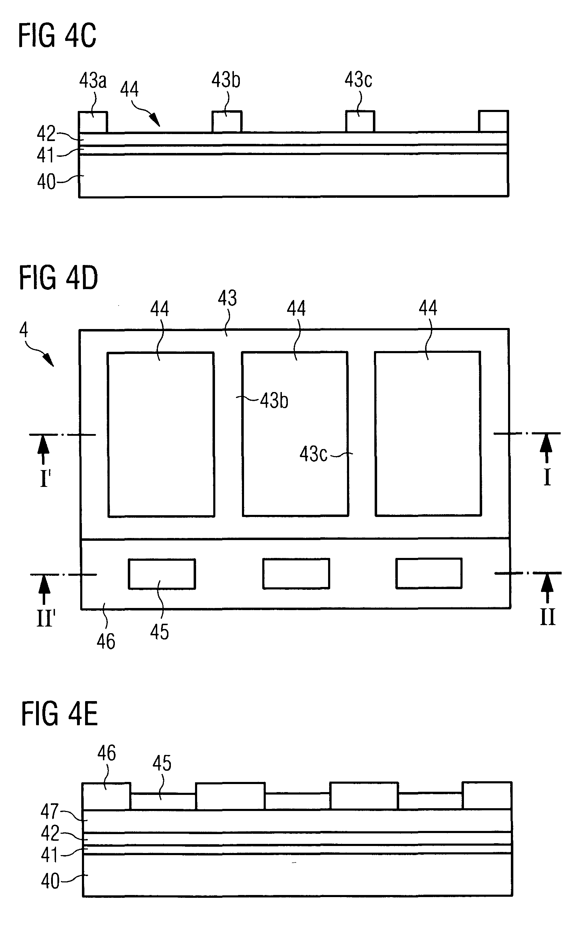

Figur 4D zeigt einen Ausschnitt eines Trägers in Draufsicht zur Darstellung der einzelnen strukturierten ersten und zweiten Teilbereiche 43a, 43b, 43c und 44. Der Schnitt entlang der Achse I'-I entspricht der Querschnittsdarstellung gemäß Figur 4C. In den zweiten Teilbereichen 44 liegt die metallische Oberfläche frei.

In einem unteren Bereich der Draufsicht sind zusätzlich Kontaktpads 45 freigelegt, die von einer dielektrischen Schutzschicht 46 umgeben sind. Die Querschnittsdarstellung entlang der Linie II'-II ist in Figur 4E dargestellt. Auf der Metallisierungsschicht 42 ist zur elektrischen Isolation eine weitere dielektrische Schicht 47 aufgebracht. Alternativ kann diese Schicht 47 auch durch die Lötstoppschicht gebildet werden, sofern diese elektrisch isolierend wirkt. Auf der dielektrischen Schicht 47 sind die Kontaktelemente 45 als Kontaktfahnen und Kontaktpads abgeschieden. Zur Verhinderung einer Oxidation der Kontaktpads und Reduzierung einer Kurzschlusswahrscheinlichkeit sind diese von einer weiteren dielektrischen Schutzschicht 46 umgeben. Die Kontaktfahnen zur Zuführung elektrischer Energie an die Kontaktpads 45 sind im dargestellten Beispiel von der Schutzschicht 46 bedeckt.

Folglich liegen lediglich die Kontaktpads 45 frei, die beispielsweise über eine Bonddrahtverbindung mit den optoelektronischen Bauelementen in den Teilbereichen 44 verbunden sind. In einem hier nicht dargestellten Abschnitt des Trägers 4 sind in der dielektrischen Schicht 47 Kontaktlöcher vorgesehen, welche einen elektrischen Kontakt zur metallischen Schicht 42 und damit den optoelektronischen Bauelementen in den Teilbereichen 44 ermöglichen.

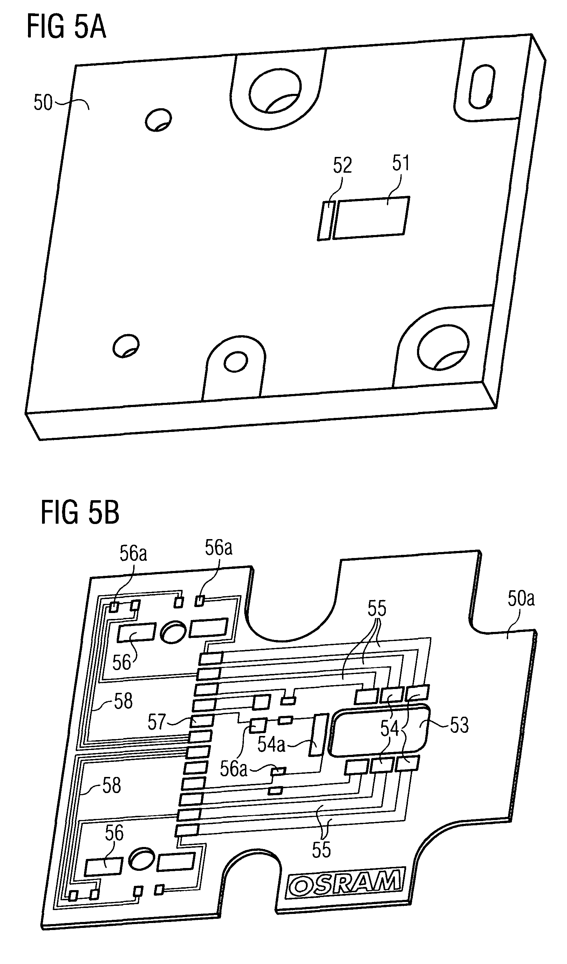

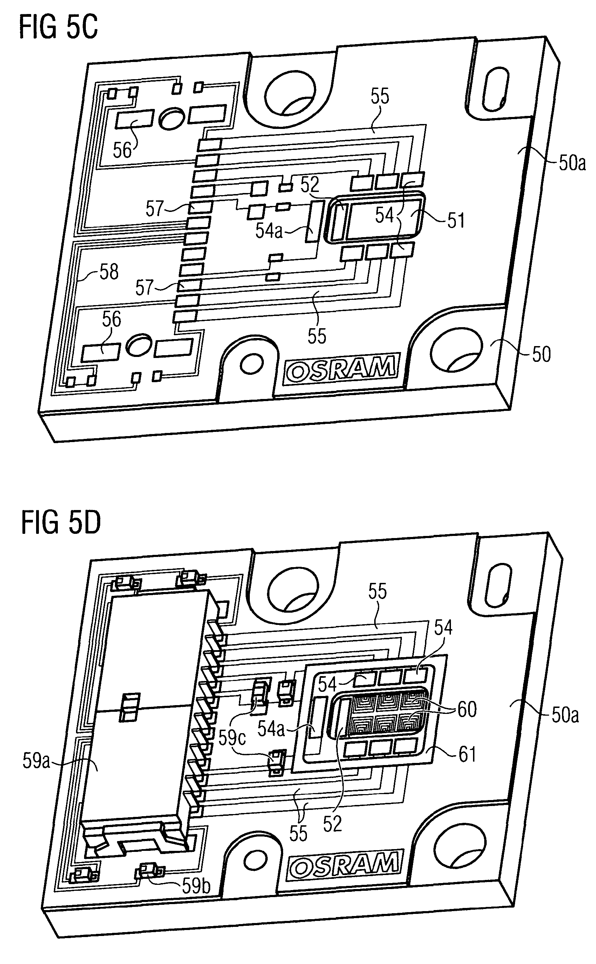

Die Figuren 5A bis 5D zeigen ein erfindungsgemäßes Ausführungsbeispiel eines Verfahrens zur Fertigung von Leuchtmitteln. Bei diesem Verfahren wird ein als Wärmesenke dienender Träger 50, beispielsweise ein Kupferkern, ein Keramikkern, ein PCB, ein Leadframe oder ein ähnlicher Träger mit hoher Wärmeleitfähigkeit in einem Chipmontagebereich 51 sowie in einem Wire-Bond-Bereich 52 mit metallisch elektrisch leitfähigen Schichten bedeckt. Hierbei steht der Wire-Bond-Bereich 52 und der Chipmontagebereich 51 in einem elektrischen leitenden Kontakt. Die weiteren vorhandenen Aussparungen auf dem als Wärmesenke dienenden Träger stellen Befestigungselemente dar, mit denen das später hergestellte Bauelement an weiteren Elementen befestigt werden kann.

Figur 5B zeigt eine Dünn-Leiterplatte für den modularen Aufbau mit den entsprechenden Aussparungen in Laminattechnik. Die Dünn-Leiterplatte 50a umfasst einen Kunststoff, in den in einer oder mehreren Lagen verschiedene Kontaktleitungen.55 bzw. 58 eingearbeitet sind. Auf der Oberfläche der DünnLeiterplatte sind Kontaktelemente 54, 54a, 56, 56a und 57 angeordnet. Diese liegen frei, während die Kontaktleitungen 55 mit einer dünnen Schutzschicht zum Schutz vor Beschädigung überzogen sein können. Die Kontaktelemente umfassen beispielsweise eine Kupferschicht bzw. eine dünne Kupfer-Nickel-Gold-Metallisierungsschicht. Einige der Kontaktfahnen 57 sind über Zuleitungen 55 mit den Kontaktfahnen 54 verbunden. Zudem ist eine zentrale Aussparung 53 vorgesehen, die einen späteren Zugriff auf den strukturierten Chipmontagebereich 51 und den strukturierten Wire-Bond-Bereich 52 gemäß Figur 5A ermöglicht. Die weiteren Kontaktelemente 56a, 56 und 57 können mit verschiedenen Bauelementen in SMD-Technik bestückt werden.

In einem nächsten Schritt wird die Dünn-Leiterplatte auf dem als Wärmesenke dienenden Träger 50 befestigt, beispielsweise auflaminiert. Hierzu kann es zweckmäßig sein, vor dem Laminieren eine dünne Lackschicht auf dem Träger 50 unter Aussparung des Chipmontagebereichs 51 und des Wire-Bond-Bereichs 52 aufzubringen. Durch die Laminierung der Leiterplatte auf dem Träger wird eine innige Verbindung der Dünn-Leiterplatte mit dem Träger realisiert. Gleichzeitig wirkt der Träger weiterhin als Wärmesenke.

Die Kontaktelemente 54 sind nun benachbart zu der Aussparung und dem strukturierten Chipmontagebereich 51 angeordnet. Eine weitere Kontaktierung 54a befindet sich benachbart zu dem strukturierten Wire-Bond-Bereich 52 des Trägers 50.

In einem weiteren Schritt, dargestellt in Figur 5D, wird nun Lotpaste mittels Lotdispensverfahren auf den strukturierten Chipmontagebereich 51 aufgebracht. Ein Zerfließen des Lots wird durch die Strukturierung des Chipmontagebereichs und die Unterteilung in erste und zweite Teilbereiche verhindert, wobei die ersten Teilbereiche des Chipmontagebereichs lotabweisende Eigenschaften aufweisen. Dadurch benetzt das aufgebracht Lotmaterial lediglich die zweiten Teilbereiche. Anschließend werden die Halbleiterbauelemente 60 auf dem Chipmontagebereich angeordnet. Durch Adhäsionskräfte zwingt die Lotpaste die einzelnen optoelektronischen Bauelemente in die jeweiligen zweite Teilbereiche, wodurch sich die in der Figur 5D dargestellte regelmäßige Anordnung ergibt.

In diesem Ausführungsbeispiel erfolgte die Laminierung der Dünnfilmplatte vor dem Aufbringen des Lotes und der optoelektronischen Bauelemente. Dies ist jedoch nicht zwingend. Ebenso ist es möglich, erst mittels verschiedener Verfahren, z.B. Lotdispensverfahren oder Druckverfahren Lotmaterial auf den Chipmontagebereich aufzubringen und damit die optoelektronischen Bauelemente zu befestigen. Anschließend wird dann die Dünnleiterplatte an dem Träger befestigt.

In dem Ausführungsbeispiel in den Figuren 5A bis 5D werden sechs einzelne optoelektronische Bauelemente in "2*3"-Form im Chipmontagebereich befestigt. Entsprechend ist der Chipmontagebereich in sechs rechteckförmige zweite Teilbereiche unterteilt. Die einzelnen Kontaktpads 54 werden über Bond-Wires mit den Kontaktpads auf den optoelektronischen Bauelementen 60 verbunden. Der strukturierte Wire-Bond-Bereich 52 wird über Kontaktdrähte an das Kontaktpad 54a auf dem Laminatträger angeschlossen.

Anschließend kann mittels Lotdispensverfahrens auf den weiteren Kontaktpads Lotmaterial abgeschieden und später SMD-Bauelemente 59c, 59b bzw. Chipbausteine 59a befestigt werden. Ein aufgebrachter Schutzring 61 umgibt die Kontaktpads 54, 54a und den ausgesparten Bereich mit dem Chipmontagebereich und die Wire-Bond-Bereiche 51 bzw. 52. Durch den Schutzring 61 ist es auch möglich, das Lot für die Kontaktpads 56, 57 und 56a anstatt mit Lotdispensverfahren auch anderweitig, beispielsweise Siebdruck oder Schablonendruck, aufzubringen.

Durch die Strukturierung eines Chipmontagebereichs zur Unterteilung in erste und zweite Teilbereiche lassen sich optoelektronische Bauelemente und im Allgemeinen Leuchtkörper an vorher gut definierten Positionen mittels eines Lotmaterials befestigen. Dadurch wird eine Positionierung einzelner Bauelemente innerhalb eines großflächigen Chipmontagebereichs verbessert.

Zu diesem Zweck ist der erste Teilbereich nach dem Strukturieren lotabweisend, d. h. ein aufgebrachtes Lotmaterial benetzt diesen Teilbereich nicht. Entsprechend werden bei einem Anordnen optoelektronischer Bauelemente auf dem Lotmaterial diese durch das Lotmaterial in den zweiten Teilbereich gezogen und dort fixiert. Eine Strukturierung kann beispielsweise durch entsprechendes Aufbringen von Lötstoppschichten erfolgen. Alternativ ist es auch möglich, bereits auf dem als Wärmesenke dienenden Träger im Chipmontagebereich befindliche Metallschichten zu entfernen bzw. zu oxidieren, sodass diese lotabweisende Eigenschaften aufweisen. Gerade Letztere ermöglicht unter Verwendung von Laserstrukturierungsverfahren besonders feine und schmale Strukturen.

## Patentansprüche

1. Verfahren zur Fertigung von Leuchtmitteln, umfassend:
- Bereitstellen eines als Wärmesenke dienenden Trägers (10a, 4, 50), der einen flächigen Chipmontagebereich (20, 51) umfasst;
- Strukturieren des flächigen Chipmontagebereichs (51, 20) zur Erzeugung eines ersten Teilbereichs (17, 24, 21a, 43) und wenigstens eines zweiten Teilbereichs (12a, 22a, 22b, 23, 44), wobei der erste Teilbereich (17, 24, 21a, 43) nach dem Strukturieren lotabweisend ist;
- Aufbringen eines Lotes auf den flächigen Chipmontagebereich (51, 20), so dass dieses den wenigstens einen zweiten Teilbereich (12a, 22a, 22b, 23, 44) benetzt;
- Aufbringen wenigstens eines optoelektronischen Bauelementes (100, 60) auf das Lot in dem wenigstens einen zweiten Teilbereich (12a, 22a, 22b, 23, 44);
- Ausbilden einer elektrischen Kontaktierung geeignet zur Zuführung elektrischer Energie an das optoelektronische Bauelement (100, 60);
**gekennzeichnet durch**:
- Ausbilden einer Dünnleiterplatte (50a) mit einer Aussparung, wenigstens einer metallischen Leitungsbahn (55) und wenigstens einem Kontaktbereich (54); und
- Aufbringen der Dünnleiterplatte (50a) auf den Träger derart, dass die Aussparung über dem Chipmontagebereich zu liegen kommt, wobei das Aufbringen des wenigstens einen optoelektronischen Bauelements (60) vor oder nach dem Aufbringen der Dünnleiterplatte (50a) erfolgt.

2. Verfahren nach Anspruch 1, wobei der flächige Chipmontagebereich (51, 20) in dem zweiten Teilbereich (12a, 22a, 22b, 23, 44) wenigstens eine metallische durch das Lot zumindest teilweise benetzbare Teilschicht (12, 42) umfasst.

3. Verfahren nach einem der Ansprüche 1 bis 2, bei dem das Strukturieren des flächigen Chipmontagebereichs umfasst:
- Aufbringen einer Lötstopschicht (43) auf dem flächigen Chipmontagebereich (51, 20), wobei die Lötstopschicht lotabweisend ist;
- Strukturieren der Lötstopschicht zur Erzeugung des ersten und des zweiten Teilbereichs (44);
- Entfernen der Lötstopschicht im zweiten Teilbereich (44).

4. Verfahren nach einem der Ansprüche 1 bis 2, bei dem das Strukturieren des flächigen Chipmontagebereichs umfasst:
- Aufbringen einer Lötstopschicht auf dem ersten Teilbereich des flächigen Chipmontagebereichs, wobei die Lötstopschicht lotabweisend ist;
- eventuelles Freilegen und/oder Bearbeiten von Abschnitten des zweiten Teilbereichs, so dass dieser eine durch Lot benetzbare Oberfläche aufweist.

5. Verfahren nach einem der Ansprüche 1 bis 4, bei dem das Bereitstellen eines als Wärmesenke dienenden Trägers (50) ein Bereitstellen eines Trägers mit einem Chipmontagebereich umfasst, der eine Schichtenfolge (11, 12) aus zumindest zwei Teilschichten umfasst, von denen zumindest eine wenigstens eines der folgenden Materialien umfasst:
- Nickel
- Kupfer
- Aluminium
- Silber
- Gold
- Titan
- Wolfram.

6. Verfahren nach einem der Ansprüche 1 bis 5, bei dem der erste Teilbereich zumindest entlang den Rändern des Chipmontagebereichs verläuft.

7. Verfahren nach einem der Ansprüche 1 bis 6, bei dem wenigstens zwei benachbarte zweite Teilbereiche durch einen ersten Teilbereich getrennt sind.

8. Verfahren nach einem der Ansprüche 1 bis 7, bei dem das Ausbilden einer elektrischen Kontaktierung umfasst:
- Bonden eines Kontaktdrahtes an ein außerhalb des Chipmontagebereichs befindliches Kontaktpad;
- Bonden des Kontaktdrahtes an ein Kontaktpad auf dem optoelektronischen Bauelement, wobei das Kontaktpad eine Teilschicht einer zur Lichtemission geeigneten Schichtenfolge elektrisch kontaktiert.

9. Verfahren nach einem der Ansprüche 1 bis 8, bei dem das optoelektronische Bauelement an seiner dem Lot zugewandten Seite eine reflektierende Schicht umfasst.

10. Verfahren nach einem der Ansprüche 1 bis 9, bei dem das optoelektronische Bauelement an seiner dem Lot abgewandten Seite ein Kontaktpad umfasst.

## Claims

1. Method for producing luminous means, comprising:
- providing a carrier (10a, 4, 50) serving as heat sink, said carrier comprising a planar chip mounting region (20, 51);
- structuring the planar chip mounting region (51, 20) for the purpose of producing a first partial region (17, 24, 21a, 43) and at least one second partial region (12a, 22a, 22b, 23, 44), wherein the first partial region (17, 24, 21a, 43) is solder-repellent after structuring;
- applying a solder to the planar chip mounting region (51, 20), such that said solder wets the at least one second partial region (12a, 22a, 22b, 23, 44);
- applying at least one optoelectronic component (100, 60) to the solder in the at least one second partial region (12a, 22a, 22b, 23, 44);
- forming an electrical contact-connection suitable for feeding electrical energy to the optoelectronic component (100, 60);
**characterized by**
- forming a thin circuit board (50a) having a cutout, at least one metallic conduction track (55) and at least one contact region (54); and
- applying the thin circuit board (50a) to the carrier in such a way that the cutout is located above the chip mounting region, wherein the at least one optoelectronic component (60) is applied before or after the thin circuit board (50a) is applied.

2. Method according to Claim 1, wherein the planar chip mounting region (51, 20) comprises in the second partial region (12a, 22a, 22b, 23, 44), at least one metallic partial layer (12, 42) which is at least partly wettable by the solder.

3. Method according to either of Claims 1 and 2, wherein structuring the planar chip mounting region comprises:
- applying a soldering resist layer (43) on the planar chip mounting region (51, 20) wherein the soldering resist layer is solder-repellent;
- structuring the soldering resist layer for the purpose of producing the first and the second partial region (44);
- removing the soldering resist layer in the second partial region (44).

4. Method according to either of Claims 1 and 2, wherein structuring the planar chip mounting region comprises:
- applying a soldering resist layer on the first partial region of the planar chip mounting region, wherein the soldering resist layer is solder-repellent;
- possibly uncovering and/or processing sections of the second partial region, such that the latter has a surface that is wettable by solder.

5. Method according to any of Claims 1 to 4, wherein providing a carrier (50) serving as heat sink comprises providing a carrier having a chip mounting region, which comprises a layer sequence (11, 12) composed of at least two partial layers, at least one of which comprises at least one of the following materials:
- nickel
- copper
- aluminum
- silver
- gold
- titanium
- tungsten.

6. Method according to any of Claims 1 to 5, wherein the first partial region runs at least along the edges of the chip mounting region.

7. Method according to any of Claims 1 to 6, wherein at least two adjacent second partial regions are separated by a first partial region.

8. Method according to any of Claims 1 to 7, wherein forming an electrical contact-connection comprises:
- bonding a contact wire onto a contact pad situated outside the chip mounting region;
- bonding the contact wire onto a contact pad on the optoelectronic component, wherein the contact pad makes electrical contact with a partial layer of a layer sequence suitable for light emission.

9. Method according to any of Claims 1 to 8, wherein the optoelectronic component comprises a reflective layer at its side facing the solder.

10. Method according to any of Claims 1 to 9, wherein the optoelectronic component comprises a contact pad at its side remote from the solder.

## Revendications

1. Procédé de fabrication de moyens lumineux, comprenant:
- mise à disposition d'un support (10a, 4, 50) servant de dissipateur thermique, lequel comprend une zone de montage de puce (20, 51) plate;
- structuration de la zone de montage de puce (20, 51) plate en vue de produire une première zone partielle (17, 24, 21a, 43) et au moins une deuxième zone partielle (12a, 22a, 22b, 23, 44), la première zone partielle (17, 24, 21a, 43) étant anti-brasage après la structuration;
- application d'un métal d'apport de brasage sur la zone de montage de puce (20, 51) plate de sorte que celui-ci imprègne l'au moins une deuxième zone partielle (12a, 22a, 22b, 23, 44);
- application d'au moins un composant optoélectronique (100, 60) sur le métal d'apport de brasage dans l'au moins une deuxième zone partielle (12a, 22a, 22b, 23, 44);
- formation d'une mise en contact électrique adaptée pour acheminer de l'énergie électrique au composant optoélectronique (100, 60);
**caractérisé par**:
- formation d'une plaque conductrice mince (50a) pourvue d'une cavité, d'au moins une piste conductrice métallique (55) et d'au moins une zone de contact (54); et
- application de la plaque conductrice mince (50a) sur le support de telle sorte que la cavité se trouve au-dessus de la zone de montage de puce, l'application de l'au moins un composant optoélectronique (60) ayant lieu avant ou après l'application de la plaque conductrice mince (50a).

2. Procédé selon la revendication 1, la zone de montage de puce (20, 51) plate comprenant dans la deuxième zone partielle (12a, 22a, 22b, 23, 44) au moins une couche partielle (12, 42) métallique qui peut être imprégnée au moins partiellement par le métal d'apport de brasage.

3. Procédé selon l'une des revendications 1 à 2, avec lequel la structuration de la zone de montage de puce plate comprend:
- application d'une couche d'arrêt de brasure (43) sur la zone de montage de puce (20, 51) plate, la couche d'arrêt de brasure étant anti-brasage;
- structuration de la couche d'arrêt de brasure en vue de produire les première et deuxième zones partielles (44);
- enlèvement de la couche d'arrêt de brasure dans la deuxième zone partielle (44).

4. Procédé selon l'une des revendications 1 à 2, avec lequel la structuration de la zone de montage de puce plate comprend:
- application d'une couche d'arrêt de brasure sur la première zone partielle de la zone de montage de puce plate, la couche d'arrêt de brasure étant anti-brasage;
- éventuellement dégagement et/ou usinage de découpes de la deuxième zone partielle, de sorte que celle-ci possède une surface pouvant être imprégnée par le métal d'apport de brasage.

5. Procédé selon l'une des revendications 1 à 4, avec lequel la mise à disposition d'un support (50) servant de dissipateur thermique comprend la mise à disposition d'un support muni d'une zone de montage de puce, laquelle comprend une séquence de couches (11, 12) composée d'au moins deux couches partielles dont au moins l'une comprend au moins l'un des matériaux suivants:
- nickel
- cuivre
- aluminium
- argent
- or
- titane
- tungstène.

6. Procédé selon l'une des revendications 1 à 5, avec lequel la première zone partielle s'étend au moins le long des bords de la zone de montage de puce.

7. Procédé selon l'une des revendications 1 à 6, avec lequel au moins deux deuxièmes zones partielles voisines sont séparées par une première zone partielle.

8. Procédé selon l'une des revendications 1 à 7, avec lequel la formation d'une mise en contact électrique comprend:
- connexion d'un fil de contact à une pastille de contact qui se trouve à l'extérieur de la zone de montage de puce;
- connexion du fil de contact à une pastille de contact sur le composant optoélectronique, la pastille de contact établissant le contact avec une couche partielle d'une séquence de couches adaptée pour l'émission de lumière.

9. Procédé selon l'une des revendications 1 à 8, avec lequel le composant optoélectronique comprend une couche réfléchissante sur son côté faisant face au métal d'apport de brasage.

10. Procédé selon l'une des revendications 1 à 9, avec lequel le composant optoélectronique comprend une pastille de contact sur son côté à l'opposé du métal d'apport de brasage.
